# EUROPÄISCHE PATENTANMELDUNG

(11) **EP 3 217 772 A1**
(43) Veröffentlichungstag der Anmeldung: **13.09.2017**
(21) Anmeldenummer: 16159761.2
(22) Anmeldetag: 11.03.2016
(51) Int. Cl.: H05K 1/14, H01R 12/00, H05K 1/02, H05K 3/36, H05K 7/14

(54) **PLATINE FÜR EIN ELEKTRONISCHES STEUERGERÄT**

(71) Anmelder: Siemens Healthcare Diagnostics Products GmbH, 35041 Marburg (DE)
(72) Erfinder: Homann, Frank, 65779 Kelkheim (DE); Proch, Klaus, 35447 Reiskirchen (DE)

(57) **Zusammenfassung**

Die Erfindung betrifft eine Platine (1) für ein elektronisches Steuergerät (7) umfassend eine Mehrzahl elektrischer Schnittstellen, die Schnittstellen umfassend jeweils ein erstes Verbindungselement (2) zum Herstellen einer Mehrzahl elektrischer Kontakte zwischen der Platine (1) und einer Tochterplatine (3), wobei die ersten Verbindungselemente (2) paarweise spiegelsymmetrisch bezüglich von gedachten Spiegelebenen auf der Platine (1) angeordnet sind.

## Beschreibung

Die Erfindung liegt auf dem Gebiet der automatischen in vitro-Diagnostiksysteme. Gegenstand der Erfindung ist eine Platine für ein elektronisches Steuergerät in einem automatischen Analysegerät.

Zahlreiche Nachweis- und Analyseverfahren zur Bestimmung physiologischer Parameter in Körperflüssigkeitsproben oder anderen biologischen Proben werden heute automatisiert in großer Anzahl in automatischen Analysegeräten, auch so genannten in vitro-Diagnostiksystemen, durchgeführt.

Heutige Analysegeräte sind in der Lage, eine Vielzahl von Nachweisreaktionen und Analysen mit einer Probe durchzuführen. Um eine Vielzahl von Untersuchungen automatisiert durchführen zu können, sind diverse Vorrichtungen zum räumlichen Transfer von Messzellen, Reaktionsbehältern und Reagenzbehältern erforderlich, wie z.B. Transferarme mit Greiffunktion, Transportbänder oder drehbare Transporträder, sowie Vorrichtungen zum Transfer von Flüssigkeiten, wie z.B. Pipettiervorrichtungen. Die Geräte umfassen eine Steuereinheit, die mittels entsprechender Software dazu in der Lage ist, die Arbeitsschritte für die gewünschten Analysen weitgehend selbstständig zu planen und abzuarbeiten.

Viele der in derartigen automatisiert arbeitenden Analysegeräten verwendeten Analyseverfahren beruhen auf optischen Methoden. Diese Verfahren ermöglichen den qualitativen und quantitativen Nachweis von Analyten, d.h. der nachzuweisenden oder zu bestimmenden Substanzen in Proben. Die Bestimmung klinisch relevanter Parameter, wie zum Beispiel der Konzentration oder Aktivität eines Analyten, erfolgt vielfach, indem ein Teil einer Probe mit einem oder mehreren Testreagenzien in einem Reaktionsgefäß, welches auch die Messzelle sein kann, vermischt wird, wodurch z.B. eine biochemische Reaktion oder eine spezifische Bindungsreaktion in Gang gesetzt wird, die eine messbare Veränderung einer optischen oder anderen physikalischen Eigenschaft des Testansatzes bewirkt.

Automatisch arbeitende Analysatoren, die zur Untersuchung von biologischen Körperflüssigkeiten eingesetzt werden, umfassen verschiedene Gerätebaugruppen zum Prozessieren der Probe. Beispielsweise werden die benötigten Reagenzien mittels einer Pipettiervorrichtung mit einer Pipettiernadel in eine Messküvette eingefüllt. Die Messküvette wird dabei mit einem Küvettengreifer innerhalb des automatischen Analysegerätes zu verschiedenen Positionen mittels eines Robotorarms automatisch verfahren, der Teil einer Robotorstation ist. Nach der Messung wird die benutzte Messküvette z.B. zur Entsorgung durch einen Abfallschacht in einen Abfallbehälter verbracht.

Ein automatisches Analysegerät kann beispielweise eine Vielzahl von verschiedenen Gerätebaugruppen umfassen, die beispielsweise einen oder mehrere Elektromotoren zum Bewegen von Robotorarmen und/oder elektronisch angetriebene und steuerbare Pumpensysteme umfassen, die jeweils von Steuergeräten gesteuert werden.

Häufig werden die verschiedenen Gerätebaugruppen über zentrale Steuergeräte gesteuert. Hierbei kann jedoch nachteilig sein, dass die Gerätebaugruppen nicht autark betrieben werden können und daher nicht einzeln bei deren Entwicklung getestet werden können. Weiter kann dabei nachteilig sein, dass Signale vom Steuergerät oder von den Gerätebaugruppen über relativ lange Kabelwege zum zentralen Steuergerät geführt werden müssen. Dies kann zu Störrungen bei der Signalübertragung führen und kann sich auch nachteilig bezüglich der elektromagnetischen Verträglichkeit des automatischen Analysegerätes auswirken.

Wünschenswert ist daher eine dezentrale Steuerung der Gerätekomponenten, beispielsweise durch lokal in räumlicher Nähe zu den jeweiligen Gerätekomponenten angeordnete, lokale Steuergeräte. Vorteilhaft ist, wenn die lokalen Steuergeräte dabei lediglich über einen Kommunikationsbus und eine Spannungsversorgung betrieben werden können. Hierzu werden jedoch lokale Steuergeräte benötigt, die lokal eigenständig eine Controllerfunktionalität zur Verfügung stellen. Aufgrund der verschiedenen, gerätebaugruppenspezifischen Anforderungen an die jeweiligen Steuergeräte werden dabei meist auf die jeweilige Gerätebaugruppe angepasste, spezielle Hardwarekomponenten für das lokale Steuergerät benötigt.
Die Entwicklung dieser speziellen Hardwarekomponenten ist sehr zeitintensiv und mit einem hohen Aufwand verbunden.

Es ist daher Aufgabe der Erfindung, ein elektronisches Steuergerät für verschiedene, gerätebaugruppenspezifische Anforderungen mit einem niedrigeren Entwicklungsaufwand zur Verfügung zu stellen.

**Diese Aufgabe wird erfindungsgemäß durch die im Folgenden beschriebenen Gegenstände und Verfahren gelöst.**

Die Erfindung geht von dem Gedanken aus, dass ein elektronisches Steuergerät für verschiedene, gerätebaugruppenspezifische Anforderungen durch Bereitstellung einer besonders flexibel einsetzbaren Platine und mit dieser Platine verbindbaren Tochterplatinen mit geringerem Entwicklungsaufwand erreicht werden kann.

Es wurde gefunden, dass eine solche besonders flexibel einsetzbare Platine bereitgestellt werden kann, indem die Platine eine Mehrzahl von Verbindungselemente zum Herstellen einer Mehrzahl elektrischer Kontakte zwischen der Platine und einer Tochterplatine umfasst, wobei die Verbindungselemente symmetrisch zueinander auf der Platine angeordnet sind, so dass sich verschiedene Tochterplatinen aufgrund der besonderen geometrischen Anordnung der Verbindungselemente besonders flexibel und einfach mit der Platine verbinden lassen. So können spezielle Hardwarekomponenten für die Steuergeräte durch Kombination der Platine mit verschiedenen Tochterplatinen mit geringerem Aufwand entwickelt und zur Verfügung gestellt werden.

Gegenstand der vorliegenden Erfindung ist eine Platine für ein elektronisches Steuergerät, die Platine umfassend eine Mehrzahl elektrischer Schnittstellen, die Schnittstellen umfassend jeweils ein erstes Verbindungselement zum Herstellen einer Mehrzahl elektrischer Kontakte zwischen der Platine und einer Tochterplatine, wobei das erste Verbindungselement mit der Platine verbunden ist und wobei das erste Verbindungselement mit einem zweiten Verbindungselement verbindbar ist und wobei das zweite Verbindungselement mit der Tochterplatine verbunden ist und wobei die ersten Verbindungselemente der Schnittstellen gleichartig ausgestaltet sind und identische Signalbelegungen aufweisen und wobei die ersten Verbindungselemente paarweise spiegelsymmetrisch bezüglich von gedachten Spiegelebenen auf der Platine angeordnet sind.

In bevorzugter Ausführung der Platine schneiden die Spiegelebenen die Ebene der Platine senkrecht oder verlaufen parallel zur Ebene der Platine.

In weiterer bevorzugter Ausführung der Platine schneiden die Spiegelebenen sich senkrecht.

In weiterer bevorzugter Ausführung der Platine weist die Platine eine erste Seite und eine zweite Seite auf, wobei die ersten Verbindungselemente sowohl auf der ersten Seite als auch auf der zweiten Seite angeordnet sind. Dies hat den Vorteil, dass auf beiden Seiten der Platine Tochterplatinen angeordnet werden können und die Zahl der mit der Platine verbindbaren Tochterplatinen entsprechend erhöht werden kann.

In weiterer bevorzugter Ausführung der Platine ist die Ebene einer Tochterplatine bei verbundenem ersten und zweiten Verbindungselement parallel zur Ebene der Platine ausgerichtet. Dies hat den Vorteil, dass ein Modul bestehend aus der Platine und einer mit der Platine verbundenen Tochterplatine besonders einfach in ein rechteckiges Gehäuse eingebaut werden kann.

In weiterer bevorzugter Ausführung der Platine beträgt die Anzahl der Schnittstellen 2 bis 16, bevorzugt 4 bis 12, besonders bevorzugt 8.

In weiterer bevorzugter Ausführung der Platine sind auf jeder Seite der Platine jeweils vier Schnittstellen angeordnet.

In weiterer bevorzugter Ausführung der Platine bilden vier erste Verbindungselemente die Ecken eines gedachten Rechtecks auf der Platine.

In bevorzugter Ausführung umfasst die Tochterplatine eins bis vier zweite Verbindungselemente.

Bevorzugt ist die Tochterplatine gleichgroß wie die Platine und umfasst die gleiche Anzahl von zweiten Verbindungselementen, wie die Platine erste Verbindungselemente auf einer Seite aufweist. Die zweiten Verbindungselemente sind bevorzugt so auf der Tochterplatine angeordnet, dass ihre Anordnung mit der Anordnung der ersten Verbindungselemente auf der Platine korrespondiert und die ersten und zweiten Verbindungelemente entsprechend verbindbar sind.

Bevorzugt ist die Tochterplatine halb so groß wie die Platine und umfasst die halbe Anzahl von zweiten Verbindungselementen, wie die Platine erste Verbindungselemente auf einer Seite aufweist.

Bevorzugt ist die Tochterplatine ein Viertel so groß wie die Platine und umfasst ein Viertel der Anzahl von zweiten Verbindungselementen, wie die Platine erste Verbindungselemente auf einer Seite aufweist.

In weiterer bevorzugter Ausführung der Platine umfassen die ersten und zweiten Verbindungselemente Signalpins, wobei die Art einer mit der Platine über die Verbindungselemente verbundenen Tochterplatine automatisch mittels der Signalpins ermittelt werden kann.

Bevorzugt umfassen die Signalpins Pull-Up- und/oder Pull-Down-Widerstände, wobei die Tochterplatine die Widerstände umfasst. Dies hat den Vorteil, dass eine Codierung über die Signalpins besonders einfach erfolgen kann.

In weiterer bevorzugter Ausführung umfassen die Signalpins eine Verbindung zur Masse oder sind geerdet. Dies hat den Vorteil, dass eine binäre Codierung über die Signalpins besonders einfach erfolgen kann.

In bevorzugter Ausführung ist eine Tochterplatine selbst eine Platine, die ihrerseits wiederum mit einer oder mehrerer weiteren Tochterplatinen verbunden werden kann. Dies hat den Vorteil, dass ein hierarchischer Aufbau der Hardwarekomponenten eines Steuergeräts besonders einfach möglich ist.

Ein weiterer Gegenstand der Erfindung ist ein elektronisches Steuergerät umfassend eine erfindungsgemäße Platine und eine Tochterplatine mit einem zweiten Verbindungselement, wobei das zweite Verbindungselement mit der Tochterplatine verbunden ist und wobei das erste Verbindungselement mit dem zweiten Verbindungselement verbindbar ist.

In bevorzugter Ausführung des Steuergeräts ist die Ebene einer Tochterplatine bei verbundenem ersten und zweiten Verbindungselement parallel zur Ebene der Platine ausgerichtet.

In weiterer bevorzugter Ausführung des Steuergeräts umfasst das Steuergerät eine Mehrzahl von Tochterplatinen, wobei die Summe der ersten Verbindungselemente auf der Platine größer oder gleich der Summe der zweiten Verbindungselemente auf den Tochterplatinen ist. Dies hat Vorteil, dass alle zweiten Verbindungselemente mit einem ersten Verbindungselement verbunden werden können.

Ein weiterer Gegenstand der Erfindung ist die Verwendung einer erfindungsgemäßen Platine und/oder eines erfindungsgemäßen Steuergeräts in einem automatischen Analysegerät. Bevorzugt werden die Platine und/oder das Steuergerät zur Steuerung eines Motors und/oder einer Pumpe verwendet.

Ein weiterer Gegenstand der Erfindung ist ein automatisches Analysegerät umfassend eine erfindungsgemäße Platine und/oder ein erfindungsgemäßes Steuergerät. Bevorzugt umfasst das automatische Analysegerät eine automatische Pipettiervorrichtung mit robotisch verfahrbaren und/oder robotisch schwenkbaren Transferarm, wobei die Steuerung des Antriebs des Transferarms mittels einer erfindungsgemäßen Platine und/oder eines erfindungsgemäßen Steuergeräts erfolgt.

Ein weiterer Gegenstand der Erfindung ist ein elektronisches Steuergerät mit einem Gehäuse für ein erfindungsgemäßes Steuergerät, wobei das Gehäuse im thermischen Kontakt mit der Platine und/oder mindestens einer Tochterplatine steht und wobei die Entwärmung der Platine und/oder der Tochterplatine über das Gehäuse erfolgt.

Bevorzugt ist die Tochterplatine schwimmend über Verbindungselemente wie z.B. elektrische Steckverbinder mit der Platine verbunden. Die Tochterplatine steht in flächigem Kontakt mit einer Innenseite des Gehäuses. Zwischen der Innenseite des Gehäuses und der Tochterplatine befindet sich vorteilhafterweise ein Wärmeleitpad und/oder eine Wärmeleitpaste zur besseren thermischen Verbindung der Tochterplatine und des Gehäuses. Bevorzugt ist das Wärmeleitpad und/oder die Wärmeleitpaste elektrisch isolierend. Vorteilhafterweise ist die Tochterplatine und das Gehäuse mit einem oder mehreren Verbindungselementen, z.B. Schrauben, verbunden. Weiter kann die Tochterplatine mit dem Verbindungselement direkt an das Gehäuse oder das Wärmeleitpad gedrückt werden. Dies verbessert ebenfalls den thermischen Kontakt zwischen Tochterplatine und Gehäuse.

Ein automatisches Analysegerät umfasst in bevorzugter Ausführung eine Vielzahl von Gerätebaugruppen. Bei den Gerätebaugruppen handelt es sich z.B. um eine beispielsweise scheibenförmige Transport- und Lagereinrichtung für Probengefäße, eine beispielsweise scheibenförmige Transport- und Lagereinrichtung für Reagenzbehälter, einen Inkubationsblock, ein Photometer oder eine andere Baugruppe des automatischen Analysegeräts, die zum Prozessieren von Proben benötigt wird.

In weiterer bevorzugter Ausführungsform befindet sich die Probe in einer nicht ortsfesten Küvette, und mindestens eine, bevorzugt mindestens zwei Gerätebaugruppen sind als Aufnahmepositionen für die Küvette ausgestaltet. Dies hat den Vorteil, dass eine Vielzahl von Proben und Analysen besonders flexibel abgearbeitet werden können.

Unter einer "Probe" ist im Sinne der Erfindung das Material zu verstehen, dass die nachzuweisende Substanz (den Analyten) vermutlich enthält. Der Begriff "Probe" umfasst insbesondere biologische Flüssigkeiten von Menschen oder Tieren wie z.B. Blut, Plasma, Serum, Sputum, Exsudat, bronchoalveoläre Lavage, Lymphflüssigkeit, Synovialflüssigkeit, Samenflüssigkeit, Vaginalschleim, Feces, Urin, Liquor, aber auch z.B. durch Homogenisation oder Zelllyse für die photometrische, bevorzugt nephelometrische Bestimmung entsprechend aufgearbeitete Gewebe- oder Zellkulturproben. Ferner können auch z.B. pflanzliche Flüssigkeiten oder Gewebe, forensische Proben, Wasser- und Abwasserproben, Nahrungsmittel, Arzneimittel als Probe dienen, die ggf. vor der Bestimmung einer entsprechenden Probenvorbehandlung zu unterziehen sind.

Bei einem quantitativen Nachweis wird die Menge, die Konzentration oder die Aktivität des Analyten in der Probe gemessen. Von dem Begriff des "quantitativen Nachweises" sind auch semiquantitative Methoden umfasst, die nur die ungefähre Menge, Konzentration oder Aktivität des Analyten in der Probe erfassen oder nur zu einer relativen Mengen-, Konzentrations- oder Aktivitätsangabe dienen können. Unter einem qualitativen Nachweis ist der Nachweis des Vorhandenseins des Analyten in der Probe überhaupt oder das Anzeigen, dass die Menge, Konzentration oder Aktivität des Analyten in der Probe unterhalb oder oberhalb eines bestimmten oder mehrerer bestimmter Schwellenwerte liegt, zu verstehen.

Bei einer Messküvette handelt es sich beispielsweise um eine Küvette oder ein Reaktionsgefäß aus Glas, Kunststoff oder Metall. Vorteilhafterweise ist die Messküvette aus optisch transparenten Materialien gefertigt, was besonders beim Einsatz von optischen Analyseverfahren vorteilhaft sein kann. Die Begriffe "Messküvette" und "Küvette" werden synonym verwendet.

Die Erfindung wird **anhand** von Zeichnungen exemplarisch näher erläutert. Darin zeigen:
FIG 1 eine schematische Darstellung einer Platine (1),
FIG 2 eine schematische Darstellung eines Steuergeräts (7) mit einer Platine (1) nach FIG 1 und drei Tochterplatinen (3).

**Gleiche Teile sind in allen Figuren mit denselben Bezugszeichen versehen.**

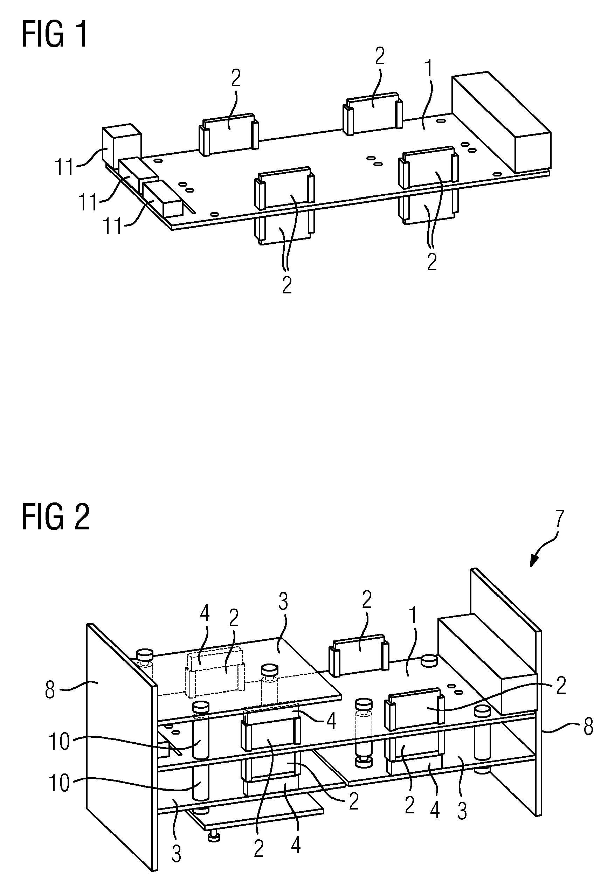

Die Platine (1) gemäß FIG 1 und das Steuergerät (7) gemäß FIG 2 befinden sich in einem nicht näher dargestellten automatischen Analysegeräts, das zum Prozessieren einer Probe ausgelegt ist und das eine Steuereinheit mit einem Computersystem zur Steuerung des Prozessierens der Probe und eine Mehrzahl von Gerätebaugruppen zum Prozessieren der Probe umfasst, wie z.B. Pipettiervorrichtungen und Transporteinrichtungen.

FIG 1 zeigt schematisch eine Darstellung einer Platine (1) ohne Tochterplatinen (3). Die Platine (1) umfasst acht erste Verbindungselemente (2). Dargestellt sind sechs erste Verbindungselemente (2), zwei weitere erste Verbindungselemente (2) sind durch die Platine verdeckt.

Die ersten Verbindungselemente (2) sind paarweise spiegelsymmetrisch bezüglich von gedachten Spiegelebenen auf der Platine angeordnet. Eine erste gedachte Spiegelebene liegt in der Ebene der Platine (1). Eine zweite und dritte gedachte Spiegelebene schneidet die Platine (1) jeweils senkrecht. Die erste, zweite und dritte gedachte Spiegelebene schneiden sich jeweils senkrecht.

Auf der Unterseite und der Oberseite der Platine (1) befinden sich jeweils vier erste Verbindungselemente (2), die ein Rechteck auf der Platine (1) bilden.

Über drei dritte Verbindungelemente (11), die mit der Platine (1) verbunden sind, ist die Platine (1) elektronisch mit weiteren elektronischen Komponenten verbindbar. Die Spannungsversorgung der Platine und die Anbindung an einen Kommunikationsbus erfolgt über die dritten Verbindungelemente (11).

FIG 2 zeigt schematisch eine Darstellung eines Steuergeräts (7) mit einer Platine (1) nach FIG 1 und drei Tochterplatinen (3). Die Platine (1) hat eine erste Seite (Unterseite) und eine zweite Seite (Oberseite). Auf der Unterseite ist die Platine (1) mit zwei Tochterplatinen (3) verbunden. Auf der Oberseite ist die Platine (1) mit einer Tochterplatine (3) verbunden. Die Tochterplatinen (3) und die Platine (1) sind parallel zueinander ausgerichtet.

Die Tochterplatinen (3) sind jeweils über zwei erste Verbindungselemente (2) und zweite Verbindungselemente (4) miteinander verbunden, die jeweils eine Mehrzahl elektrischer Kontakte zwischen der Platine (1) und Tochterplatine (3) herstellen und Teile von elektronischen Schnittstellen darstellen. Die ersten Verbindungelemente (2) sind dabei mit der Platine (1) verbunden, die zweiten Verbindungselemente (4) sind mit der Tochterplatine (3) verbunden. Sechs der ersten Verbindungselemente (2) sind mit einem zweiten Verbindungselement (4) verbunden und stellen jeweils eine Mehrzahl elektrischer Kontakte zwischen der Platine (1) und den jeweiligen Tochterplatinen (4) her. Zwei der ersten Verbindungselemente (2) sind nicht mit einem zweiten Verbindungselement (4) verbunden.

Die Platine (1) ist mittels Befestigungselementen (10), die Schrauben und je einen Abstandshalter umfassen, mit den Tochterplatinen (3) verbunden. Die Platine (1) und die Tochterplatinen (3) sind mit Gehäusewänden (8) verbunden, die Teil eines Gehäuses sind und im thermischen Kontakt mit der Platine (1) und den Tochterplatinen (3) zur Ableitung von Wärme stehen. Die Entwärmung der Platine (1) und der Tochterplatinen (3) erfolgt über das Gehäuse.

Die ersten Verbindungselemente (2) und zweiten Verbindungselemente (4) umfassen Signalpins mittels der die Art der Tochterplatine (3) automatisch erkannt wird. Die Tochterplatine (3) umfasst Pull-Up- und/oder Pull-Down-Widerstände für die Signalpins.

Die ersten Verbindungselemente (2) sind gleichartig ausgestaltet und weisen identische Signalbelegungen auf.

### Bezugszeichenliste

- 1: Platine
- 2: erstes Verbindungselement
- 3: Tochterplatine
- 4: zweites Verbindungselement
- 7: Steuergerät
- 8: Gehäusewand
- 10: Befestigungselement
- 11: drittes Verbindungelement

## Patentansprüche

1. Platine (1) für ein elektronisches Steuergerät (7), die Platine umfassend eine Mehrzahl elektrischer Schnittstellen, die Schnittstellen umfassend jeweils ein erstes Verbindungselement (2) zum Herstellen einer Mehrzahl elektrischer Kontakte zwischen der Platine (1) und einer Tochterplatine (3),
wobei das erste Verbindungselement (2) mit der Platine (1) verbunden ist und mit einem zweiten Verbindungselement (4), das mit der Tochterplatine (3) verbunden ist, verbindbar ist
und wobei die ersten Verbindungselemente (2) der Schnittstellen gleichartig ausgestaltet sind und identische Signalbelegungen aufweisen,
**dadurch gekennzeichnet, dass** die ersten Verbindungselemente (2) paarweise spiegelsymmetrisch bezüglich von gedachten Spiegelebenen auf der Platine (1) angeordnet sind.

2. Platine (1) nach Anspruch 1, wobei die Spiegelebenen die Ebene der Platine (1) senkrecht schneiden oder parallel zur Ebene der Platine (1) verlaufen.

3. Platine (1) nach einem der vorhergehenden Ansprüche, wobei die Spiegelebenen sich senkrecht schneiden.

4. Platine (1) nach einem der vorhergehenden Ansprüche, wobei die Platine (1) eine erste Seite und eine zweite Seite aufweist und wobei erste Verbindungselemente (2) sowohl auf der ersten Seite als auch auf der zweiten Seite angeordnet sind.

5. Platine (1) nach einem der vorhergehenden Ansprüche, wobei die Anzahl der Schnittstellen 2 bis 16, bevorzugt 4 bis 12, besonders bevorzugt 8 beträgt.

6. Platine (1) nach einem der vorhergehenden Ansprüche, wobei vier erste Verbindungselemente (2) die Ecken eines gedachten Rechtecks auf der Platine bilden.

7. Platine (1) nach einem der vorhergehenden Ansprüche, wobei die ersten (2) und zweiten (4) Verbindungselemente Signalpins umfassen und wobei die Art einer mit der Platine (1) über die Verbindungselemente (2, 4) verbundenen Tochterplatine (3) automatisch mittels der Signalpins ermittelt werden kann.

8. Elektronisches Steuergerät (7) umfassend eine Platine (1) nach einem der Ansprüche 1 bis 7 und eine Tochterplatine (3) mit einem zweiten Verbindungselement (4), wobei das zweite Verbindungselement (4) mit der Tochterplatine (3) verbunden ist und wobei das erste Verbindungselement (2) mit dem zweiten Verbindungselement (4) verbindbar ist.

9. Elektronisches Steuergerät (7) nach Anspruch 8, wobei die Ebene einer Tochterplatine (3) bei verbundenem ersten (2) und zweiten (4) Verbindungselement parallel zur Ebene der Platine (1) ausgerichtet ist.

10. Elektronisches Steuergerät (7) nach einem der Ansprüche 8 und 9, wobei das Steuergerät (7) eine Mehrzahl von Tochterplatinen (3) umfasst und wobei die Summe der ersten Verbindungselemente (2) auf der Platine größer oder gleich der Summe der zweiten Verbindungselemente (4) auf den Tochterplatinen (3) ist.

11. Verwendung einer Platine (1) nach einem der Ansprüche 1 bis 7 und/oder eines Steuergeräts (7) nach einem der Ansprüche 8 bis 10 in einem automatischen Analysegerät.

12. Verwendung einer Platine (1) oder eines Steuergeräts (7) nach Anspruch 11 zur Steuerung eines Motors und/oder einer Pumpe.

13. Automatisches Analysegerät umfassend eine Platine (1) nach einem der Ansprüche 1 bis 7 und/oder ein Steuergerät (7) nach einem der Ansprüche 8 bis 10.

14. Automatisches Analysegerät nach Anspruch 13,
wobei das automatische Analysegerät eine automatische Pipettiervorrichtung mit einem robotisch verfahrbaren und/oder robotisch schwenkbaren Transferarm und eine Platine (1) nach einem der Ansprüche 1 bis 7 und/oder ein Steuergerät (7) nach einem der Ansprüche 8 bis 10 umfasst und wobei die Steuerung des Antriebs des Transferarms mittels der Platine (1) und/oder des Steuergeräts (7) erfolgt.

15. Elektronisches Steuergerät (7) nach einem der Ansprüche 8 bis 10 mit einem Gehäuse, wobei das Gehäuse im thermischen Kontakt mit der Platine (1) und/oder der Tochterplatine (3) steht und wobei die Entwärmung der Platine (1) und/oder der Tochterplatine (3) über das Gehäuse erfolgt.
